# EUROPÄISCHE PATENTSCHRIFT

(11) **EP 3 117 452 B1**
(45) Veröffentlichungstag und Bekanntmachung des Hinweises auf die Patenterteilung: **06.05.2020**
(21) Anmeldenummer: 15717081.2
(22) Anmeldetag: 03.03.2015
(51) Int. Cl.: H01L 21/66, H01L 23/00

(54) **VERFAHREN ZUM BESTIMMEN EINER BONDVERBINDUNG IN EINER BAUTEILANORDNUNG UND PRÜFVORRICHTUNG**
METHOD FOR DETERMINING A BONDING CONNECTION IN A COMPONENT AND TEST APPARATUS
PROCÉDÉ DE DÉTERMINATION D'UNE CONNEXION DE FIL DANS UN COMPOSANT ET DISPOSITIF DE TEST

(30) Priorität: 10.03.2014 DE 102014103180
(43) Veröffentlichungstag der Anmeldung: 18.01.2017
(73) Patentinhaber: Fraunhofer-Gesellschaft zur Förderung der angewandten Forschung e.V., 80686 München (DE); Technische Universität Berlin, 10623 Berlin (DE)
(72) Erfinder: MIDDENDORF, Andreas, 14532 Kleinmachnow (DE); NOWAK, Torsten, 12489 Berlin (DE); JANZEN, Sergei, 12051 Berlin (DE)
(74) Vertreter: Bittner, Thomas L.
(86) Internationale Anmeldenummer: PCT/DE2015/100082
(87) Internationale Veröffentlichungsnummer: WO 2015/135529

(56) Entgegenhaltungen:
- CN-A- 103 579 032
- DE-A1-102010 038 130
- JP-A- H0 294 454
- JP-A- H0 774 202
- JP-A- S6 073 347
- US-A- 5 101 263
- ALI SHAKOURI ET AL: "Ultrafast submicron thermal characterization of integrated circuits", PHYSICAL AND FAILURE ANALYSIS OF INTEGRATED CIRCUITS (IPFA), 2012 19TH IEEE INTERNATIONAL SYMPOSIUM ON THE, IEEE, 2. Juli 2012 (2012-07-02), Seiten 1-2, XP032238780, DOI: 10.1109/IPFA.2012.6306334 ISBN: 978-1-4673-0980-6

## Beschreibung

Die Erfindung betrifft ein Verfahren zum Bestimmen einer Bondverbindung in einer Bauteilanordnung sowie eine Prüfvorrichtung.

### Hintergrund

Das Bonden wird insbesondere genutzt, um die bei einem elektronischen Schaltkreis außen sichtbaren Anschlüsse, die auch als Pins bezeichnet werden, über Bonddrähte mit Chip-Anschlüssen zu verbinden, die metallische Kontaktstellen bilden. Hierbei übernimmt der Bonddraht insbesondere die Funktion der elektrischen Verbindung zwischen der integrierten Schaltung und einem Verdrahtungsträger.

Beim Herstellen derartiger Bauteilanordnungen gilt besonderes Augenmerk der korrekten Ausbildung der Bondverbindungen, so dass diese im Betrieb den notwendigen Stromfluss garantieren. Hierbei wird einerseits versucht, Bondverbindungen mit verbesserten Eigenschaften bereit zu stellen. Im Dokument DE 10 2010 038 130 A1 wird für eine Dickdraht-Bondanordnung vorgeschlagen, am Ende des Bonddrahtes im Bereich des Bondabschnitts, für den die Bondverbindung ausgebildet wird, einen Verjüngungsabschnitt vorzusehen.

Im Dokument US 5,101,263 A ist ein plastikverkapseltes Halbleiterbauteil offenbart, bei dem ein Draht mit einer an den Bondbereich angrenzenden Struktur versehen ist, in die sich das zur Verkapselung genutzte Plastik einfügt. Dadurch soll eine Relativbewegung des Drahts zur Verkapselung aufgrund thermischer Ausdehnung verhindert werden, da es aufgrund der Bewegung zu einem Bruch des Drahts kommen kann.

Das Dokument JP H07 74202 offenbart das Anbringen von Markierungen auf einem Draht, um mithilfe eines Detektors die korrekte Länge des Drahts zu überprüfen.

Zur Sicherung der ausreichenden elektrischen Kontaktierung im Zusammenhang mit Bondverbindungen wird in der Produktion nach dem Herstellen der Bauteilanordnung mit einer oder mehreren Bondverbindungen stichprobenartig deren korrekter Ausführung geprüft. Hierzu wird ein sogenannter Schertest genutzt, bei dem am Prüfmuster die Bondverbindungen mit Scherkräften beaufschlagt werden, um deren mechanische Stabilität zu prüfen.

Im Dokument CN 103 579 032 A wird vorgeschlagen, die Aluminium-Bondverbindung nach dem Herstellen thermisch mittels Thermosensorik zu untersuchen. Es ist der Einsatz von Infrarot-Bildgebung vorgesehen, um eine Temperaturverteilung zu bestimmen.

Im Dokument WO 2011 / 156527 A1 ist ein Verfahren zum nicht zerstörenden Prüfen von elektronischen Bauteilen offenbart. Mittels Lock-in Thermografie (LIT) sollen dreidimensional sogenannte Hot Spots bestimmt werden.

Das Dokument JP H02 94454 offenbart ein Verfahren zum Prüfen einer Bondverbindung, bei dem der gebondete Bereich direkt nach dem Bonden mit einem Strom beaufschlagt wird. Ein Bild der Wärmeverteilung, welches davon abhängt, ob der Bondvorgang befriedigend abgeschlossen wurde, wird durch einen Infrarotfilter eines optischen Sensors erfasst, um den Zustand des gebondeten Bereichs durch einen Vergleich mit einem Referenzbild zu bestimmen.

Im Dokument JP S60 73347 A wird vorgeschlagen, Defekte in einer Bondverbindung zu erkennen, indem die Verbindung mittels eines Lasers erwärmt wird und aufgrund der mittels eines Detektors erfassten Wärmestrahlung die Temperaturänderung bestimmt wird.

### Zusammenfassung

Aufgabe der Erfindung ist es, ein Verfahren zum Bestimmen einer Bondverbindung in einer Bauteilanordnung, insbesondere Dickdrahtbondverbindung, sowie eine Prüfvorrichtung vorzuschlagen, mit denen auch bei der Massenfertigung von Bauteilanordnungen die korrekte Ausbildung einer Bondverbindung auf einfache und zuverlässige Art und Weise geprüft werden kann.

Zur Lösung der Aufgabe ist ein Verfahren zum Bestimmen einer Bondverbindung in einer Bauteilanordnung nach dem unabhängigen Anspruch 1 vorgeschlagen. Weiterhin ist eine Prüfvorrichtung zum Bestimmen einer Bondverbindung in einer Bauteilanordnung nach dem unabhängigen Anspruch 12 vorgesehen. Vorteilhafte Ausgestaltungen sind Gegenstand von abhängigen Unteransprüchen.

Nach einem Aspekt ist ein Verfahren zum Bestimmen oder Prüfen einer Bondverbindung in einer Bauteilanordnung geschaffen, bei dem eine Bondverbindung zwischen einem Bondabschnitt eines Bonddrahtes und einer metallischen Kontaktstelle hergestellt wird. Es ist vorgesehen, eine deckseitige Oberfläche des Bonddrahtes im Bereich des Bondabschnittes zu strukturieren. Dieses kann vor dem Bonden des Drahtes und / oder nach dem Ausbilden der Bondverbindung durchgeführt werden. Es kann vorgesehen sein, den Bonddraht im Bereich des Bondabschnittes mit Markierungen zu versehen, die den Bereich für die Oberflächenstrukturierung vor und / oder nach dem Bonden markieren. Bei dem Strukturieren kann die deckseitige Oberfläche des Bonddrahtes zum Beispiel mit mehreren Vertiefungen versehen werden. Das Strukturieren der deckseitigen Oberfläche des Bonddrahtes erfolgt die Betriebsstromleitfähigkeit aufrechterhaltend. Dieses bedeutet, dass der gebondete Draht nach dem Strukturieren weiterhin geeignet ist, die für den Betrieb der Bauteilanordnung vorgesehene elektrische oder elektronische Funktion der Bondverbindung zu leisten. Das Prüfen der Bondverbindung kann dann im Rahmen einer nichtzerstörenden Prüfung ausgeführt werden.

Beim Bestimmen oder Prüfen der Bondverbindung wird eine Prüfspannung an den Bonddraht und die Bondverbindung angelegt, so dass sich die Bondverbindung aufgrund eines hierdurch induzierten Stromflusses erwärmt. Folge hiervon ist Wärmestrahlung. Die erwärmte Bondverbindung wird mit Hilfe einer Thermografieaufnahme aufgenommen. Die Thermografieaufnahme wird ausgewertet, um zu bestimmen, ob die Bondverbindung korrekt hergestellt wurde, also insbesondere den betriebsnotwendigen Stromfluss funktionsgerecht gewährleisten kann.

Die im Bereich der deckseitigen Oberfläche des Bonddrahtes im Bereich des Bondabschnittes gezielt hergestellte Strukturierung ist verschieden von und zusätzlich einer eventuell zufällig oder herstellungsbedingt auftretenden Oberflächenänderung (Konturierung), die durch den Einsatz der Bondwerkzeuge, zum Beispiel einer Sonotrode, beim Bonden an sich verursacht sein kann.

Die im Bereich des Bondabschnittes aufgebrachte Strukturierung der deckseitigen Oberfläche unterstützt eine gute Sichtbarkeit des Bereichs mit der Bondverbindung in der Thermografieaufnahme, so dass im Anschluss die gewünschte Auswertung durchgeführt werden kann. Die Thermografie ist ein bildgebendes Verfahren zum Anzeigen der Oberflächentemperatur des betrachteten Objektes. Im Unterschied zu einer eventuell zufällig auftretenden Oberflächenveränderung, die insbesondere die Folge der Anwendung des Bondwerkzeugs sein kann, wird mittels der gezielt vorgesehenen und insoweit künstlich erzeugten Oberflächenstrukturierung eine für die jeweilige Strukturierung charakteristische Infrarotstrahlung bewirkt, die in der Thermografieaufnahme detektiert wird. Zum Aufnehmen kommen zum Beispiel Wärmebildkameras zum Einsatz.

Die Thermografieaufnahme kann ein oder mehrere Thermografieabbildungen umfassen. Alternativ oder ergänzend kann vorgesehen sein, Videofilmaufnahmen zu nutzen.

Beim Integrieren des Prüfverfahrens zum Bestimmen der Bondverbindung in einen Produktionsprozess zum Herstellen von Bauteilanordnungen kann das Verfahren stichprobenartig parallel zum Produktionsprozess durchgeführt werden, wobei alle Bondverbindungen der geprüften Bauteilanordnung untersucht werden können. Wenn festgestellt wird, dass die untersuchte Bondverbindung korrekt hergestellt wurde, kann die untersuchte Bauteilanordnung zurück in den Produktionsprozess gegeben werden oder, wenn dieser für die untersuchte Bauteilanordnung schon beendet ist, als weiter nutzbare Bauteilanordnung zurückgegeben werden.

Nach einem weiteren Aspekt ist eine Prüfvorrichtung zum Bestimmen oder Prüfen einer Bondverbindung in einer Bauteilanordnung geschaffen, welche für das vorangehende Verfahren geeignet ist. Die Prüfvorrichtung weist eine Strukturierungseinrichtung auf, die eingerichtet ist, eine deckseitige Oberfläche eines Bonddrahtes im Bereich eines Bondabschnittes zu strukturieren, für den nach oder vor dem Strukturieren eine Bondverbindung zu einer metallischen Kontaktstelle hergestellt ist. Mit einer Prüfeinrichtung wird die Bondverbindung bestimmt, wobei die Prüfeinrichtung eingerichtet ist, mittels einer Spannungsquelle hierbei eine Prüfspannung an den Bonddraht und die Bondverbindung anzulegen, so dass sich die Bondverbindung aufgrund von Stromfluss erwärmt. Weiterhin weist die Prüfeinrichtung eine Thermografie-Aufnahmeeinrichtung auf, zum Beispiel eine Wärmebildkamera, mit der eine Thermografieaufnahme für die erwärmte Bondverbindung aufnehmbar ist. Zur Auswertung der Thermografieaufnahme ist eine Auswerteeinrichtung vorgesehen, mit der bestimmbar ist, ob die Bondverbindung korrekt hergestellt wurde, indem die Thermografieaufnahme analysiert wird. Teil der Auswerteeinrichtung kann insbesondere eine Datenverarbeitungseinrichtung sein, zum Beispiel ein Computer, mit dem die Thermografieaufnahme in digitalisierter Form verarbeitet werden kann, um zu bestimmen, ob die auf der Thermografieaufnahme gezeigte Bondverbindung korrekt und funktionsgerecht hergestellt wurde. Auch kann die Auswerteeinrichtung eine Anzeigevorrichtung zum Darstellen der Thermografieaufnahme aufweisen.

Dadurch, dass aufgrund des Anlegens der Prüfspannung nur in der oder den Bondverbindungen Hot-spots entstehen, ist eine Thermografieaufnahme höher ortsaufgelöst und genauer hinsichtlich der Temperaturbestimmung.

Beim Anlegen der Prüfspannung kann wenigstens eine durchschnittliche Betriebsspannung für die Bondverbindung beim Einsatz der Bauteilanordnung erreicht werden. Die angelegte Betriebsspannung kann den Wert einer höchstens zulässigen Betriebsspannung für die Bauteilanordnung erreichen und wahlweise überschreiten innerhalb einer zulässigen (zerstörungsfreien) Grenze. Bei dieser oder anderen Ausführungsformen können Prüfspannungsimpulse mit einer Prüfwiederholfrequenz angelegt werden, sodass die Bondverbindung mehrfach erwärmt wird. Getriggert mittels der Frequenz des Anlegens der Prüfimpulse können mehrere Thermografieaufnahmen gemacht werden und in die Bestimmung der korrekten Ausbildung der Bondverbindung einbezogen werden.

Bei einer Ausgestaltung kann vorgesehen sein, dass beim Bestimmen die Thermografleaufnahme mit einer oder mehreren Referenz-Thermografieaufnahmen verglichen wird. Die Referenz-Thermografieaufnahmen oder -abbildungen können zum Vergleich korrekt ausgebildete und / oder nicht korrekt ausgebildete Bondverbindungen zeigen, so dass aus dem Vergleich auf den Charakter der untersuchten Bondverbindung geschlossen werden kann. Der Vergleich kann mittels digitaler Bildverarbeitung durchgeführt werden. Hierbei kann vorgesehen sein, bei der Bildanalyse zunächst anhand der oberflächenseitigen Strukturierung die eine oder die mehreren Bondverbindungen zu selektieren, um dann nur für diese Bildbereiche eine weitere Bildanalyse anhand der Temperaturinformation auszuführen. Die Nutzung der digitalen Bildverarbeitung eröffnet die Möglichkeit der Speicherung der Bilddaten in einer Datenbank, um zyklisch zu prüfen, ob eine Degradation stattfindet. Es kann vorgesehen sein, dass für die Bauteilanordnung mehrere Bondverbindungen geprüft werden und die Bauteilanordnung als Ausschuss verworfen wird, wenn wenigstens eine der geprüften Bondverbindungen als nicht korrekt hergestellt bestimmt wird.

Beim Bestimmen wird die zumindest eine Thermografieaufnahme mittels digitaler Bildauswertung ausgewertet. Bei der digitalen Bildauswertung ist vorgesehen, dass mit deren Hilfe in der Thermografieaufnahme nach charakteristischen Bildmustern gesucht wird, die der Strukturierung der deckseitigen Oberfläche des Bonddrahtes entsprechen, um anschließend die charakteristischen Bildmuster zum Bestimmen der Korrektheit der Bondverbindung auszuwerten. Hierbei kann vorgesehen sein, insbesondere für den Bereich der charakteristischen Bildmuster und / oder benachbart hierzu ein Erwärmungsverhalten zeitaufgelöst und / oder eine Erwärmungsendtemperatur zu bestimmen. Diese und andere aus der Bildauswertung bestimmbare Parameter können mit hinterlegten Referenz-Parametern verglichen werden, die korrekt gebildete und / oder nicht korrekt hergestellte Bondverbindungen charakterisieren, um so schließlich ein Prüfergebnis für die untersuchte Bondverbindung zu bestimmen.

Mit der Thermografieaufnahme kann ein Zeitverhalten beim Erwärmen der Bondverbindung erfasst und beim Bestimmen ausgewertet werden. Hierbei kann untersucht werden, wie sich das Erwärmen der Bondverbindung aufgrund des Anlegens der Prüfspannung in zeitlicher Hinsicht entwickelt. Hierzu kann vorgesehen sein, mehrere Thermografieabbildungen in zeitlichen Abständen aufzunehmen, beispielsweise getriggert entsprechend der Wiederholfrequenz angelegter Prüfspannungsimpulse. Alternativ oder ergänzend kann ein Videofilm im Rahmen der Thermografieaufnahme aufgenommen werden. Das zeitliche Verhalten beim Erwärmen ist für korrekt und nicht korrekt hergestellte Bondverbindungen verschieden, so dass aus der Auswertung des zeitlichen Verhaltens Rückschlüsse auf die Qualität der Bondverbindungen ermöglicht sind.

Eine Ausgestaltung kann vorsehen, dass beim Bestimmen für die Bondverbindung eine Endtemperatur für das Erwärmen bestimmt wird. Wie dieses als solches für Thermografieaufnahmen bekannt ist, kann mittels Bildanalyse eine der untersuchten Oberflächen zugeordnete Endtemperatur bestimmt werden. Auch hierbei zeigen sich regelmäßig Unterschiede für die Endtemperatur bei korrekt hergestellten Bondverbindungen einerseits und nicht den Anforderungen genügenden Bondverbindungen andererseits.

Das Anlegen der Prüfspannung und das Erzeugen der Thermografieaufnahme kann wiederholt ausgeführt werden. Das Anlegen der Prüfspannung kann mehrfach wiederholt werden, bevor schließlich die Korrektheit der Bondstelle mittels Bildauswertung erfolgt. Wenn mehrere Thermografieaufnahmen gemacht wurden, kann ein Mittelungsprozess vorgeschaltet werden, zum Beispiel zur Verbesserung des Signal-Rausch-Verhältnisses. Das wiederholte Anlegen der Prüfspannung kann beispielsweise mit einer Frequenz zwischen etwa 1 Hz und etwa 10 Hz erfolgen.

Beim Erwärmen der Bondverbindung kann aufgrund der angelegten Prüfspannung ein Temperaturhub von etwa Raumtemperatur auf wenigstens etwa 100°C erzeugt werden. Bei einer Ausgestaltung kann vorgesehen sein, einen Temperaturhub bis auf wenigstens etwa 150° zu erzeugen.

Die Oberflächenstrukturierung kann in beliebiger Weise ausgestaltet sein, beispielsweise mit parallel verlaufenden Strukturen wie Vertiefungen, die schräg oder quer zur Längsrichtung des Bonddrahtes ausgebildet sein können. Zur mechanischen Bearbeitung kann ein Stempel genutzt werden, mit dem die deckseitige Oberflächenstrukturierung im Bondabschnitt herstellbar ist.

Bei einer Ausgestaltung kann vorgesehen sein, dass das Bestimmen oder Prüfen, ob die Bondverbindung korrekt hergestellt wurde, als eine Online-Diagnose ausgeführt wird. Bei der Online-Diagnose können Referenz-Thermografieaufnahmen in der Auswerteeinrichtung, mit der die Thermografieaufnahme ausgewertet wird, über eine Online-Verbindung von einer entfernten Servereinrichtung bereitgestellt werden. Alternativ oder ergänzend kann die Thermografieaufnahme vom Ort der Bildaufnahme an eine hiermit online verbundene Auswerteeinrichung übermittelt werden, um so entfernt vom Bildaufnahmeort die Bildauswertung durchzuführen.

Die Bondverbindung kann vor dem Bestimmen wenigstens abschnittsweise geschwärzt werden. Von der Schwärzung kann der Bereich der Bondverbindung und zusätzlich der Bonddraht erfasst werden. Es kann eine flächige Schwärzung vorgesehen sein, die den Bereich mehrerer oder aller Bondverbindungen und benachbarte Bereiche hierzu auf der Bauteilanordnung erfasst. Wird das Schwärzen vor dem Einbringen der oberflächenseitigen Strukturierung ausgeführt, kann zum Beispiel beim Herstellen der Strukturierung mittels Laserbearbeitung die Schwärzung in Teilbereichen wieder entfernt werden, nämlich insbesondere in den strukturierten Bereichen.

Es kann vorgesehen sein, nicht nur für die Bondverbindung Temperaturinformation aus der Thermografieaufnahme abzuleiten, sondern ergänzend für den gebondeten Chip. Für diesen kann so die Chiptemperatur bestimmt werden, ohne die gesamte untersuchte Fläche der Bauteilanordnung zu schwärzen.

Im Zusammenhang mit der Prüfvorrichtung zum Bestimmen einer Bondverbindung in einer Bauteilanordnung können die vorangehend für das Verfahren zum Bestimmen der Bondverbindung erläuterten Ausgestaltungen entsprechend vorgesehen sein.

### Beschreibung von Ausführungsbeispielen

Im Folgenden werden Ausführungsbeispiele unter Bezugnahme auf Figuren einer Zeichnung näher erläutert. Hierbei zeigen:
- Fig. 1: eine schematische Darstellung einer Prüfvorrichtung zum Bestimmen einer Bondverbindung in einer Bauteilanordnung,
- Fig. 2: eine schematische Darstellung von Bondabschnitten mit einer deckseitigen Oberflächenstrukturierung,
- Fig. 3: eine schematische Darstellung zum Ablauf eines Verfahrens zum Bestimmen einer Bondverbindung in einer Bauteilanordnung und
- Fig. 4: eine Thermografieaufnahme einer Bondverbindung, bei der der Bondabschnitt des Bonddrahtes mit quer zur Längsachse des Bonddrahtes ausgebildeten Vertiefungen versehen ist.

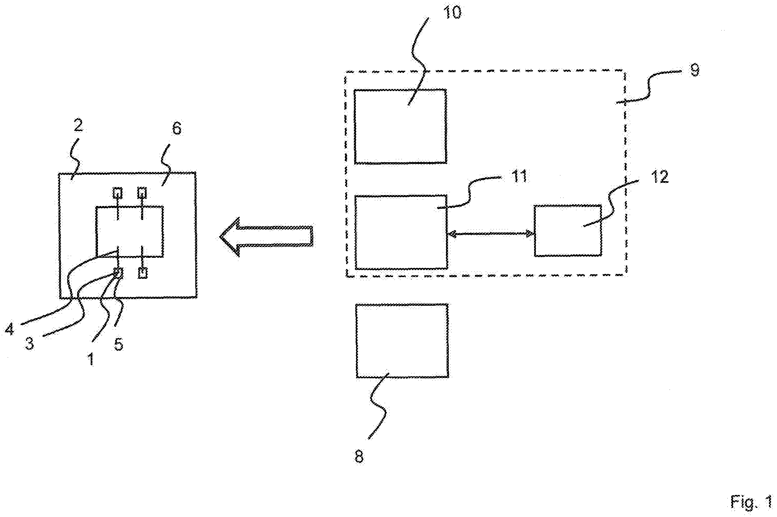

Fig. 1 zeigt eine schematische Darstellung einer Prüfvorrichtung zum optischen Bestimmen einer Bondverbindung 1 in einer Bauteilanordnung 2. Im Bereich der Bondverbindung 1 ist ein Bondabschnitt 3 eines Bonddrahtes 4 auf eine metallische Kontaktstelle 5 gebondet, die auf einem Bauteilträger 6 mit einer Verdrahtungsstruktur gebildet ist. Hierdurch wird ein Chip 7 mit dem Bauteilträger 6 kontaktiert.

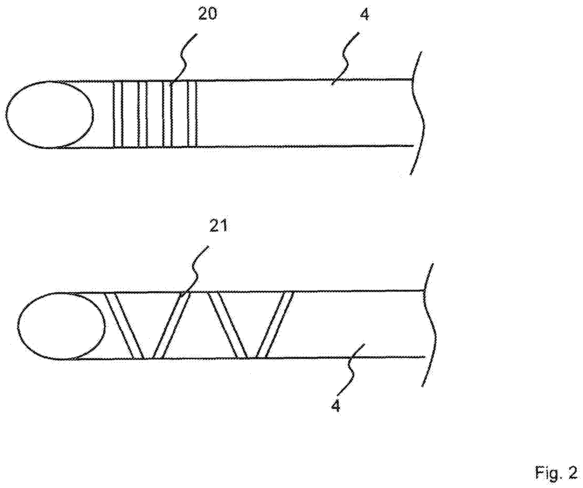

Die Prüfvorrichtung ist gebildet mit einer Strukturierungseinrichtung 8, die eingerichtet ist, eine deckseitige Oberfläche des Bonddrahtes 4 im Bereich des Bondabschnitts 3 zu strukturieren. Hierzu verfügt die Strukturierungseinrichtung 8 beispielsweise über einen Laser, mit dem der Bondabschnitt 3 oberflächenseitig bearbeitet wird, um dort eine Strukturierung herzustellen, wie dies beispielhaft in Fig. 2 gezeigt ist.

Weiterhin verfügt die Prüfvorrichtung über eine Prüfeinrichtung 9, mit der die Bondverbindung 1 auf korrekte Herstellung geprüft wird. Die Prüfeinrichtung 9 weist eine Spannungsquelle 10 auf, die eine Prüfspannung bereitstellt, um diese an den zu prüfenden Bonddraht 4 und die Bondverbindung 1 anzulegen, so dass aufgrund des hierdurch entstehenden Stromflusses sich die Bondverbindung 1 erwärmt. Die aufgrund der Erwärmung entstehende Infrarotstrahlung kann mit Hilfe einer Thermografie-Aufnahmeeinrichtung 11 aufgenommen werden. Die so erzeugte Thermografieaufnahme wird dann mit einer Auswerteeinrichtung 12 der Prüfeinrichtung 9 analysiert, um zu prüfen, ob die Bondverbindung 1 korrekt hergestellt ist.

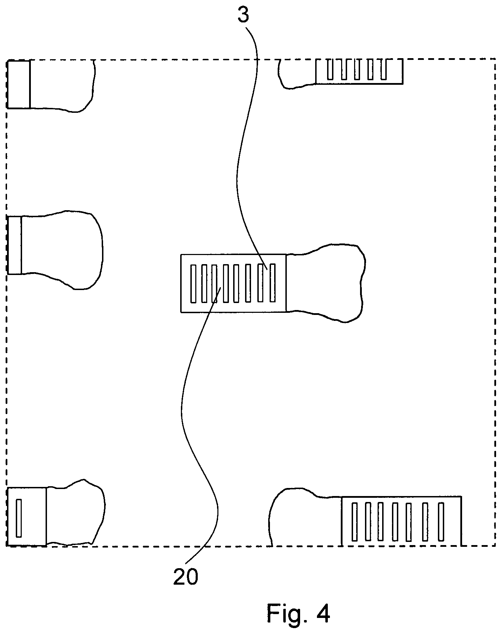

Die in Fig. 2 beispielhaft dargestellten Oberflächenstrukturierungen 20, 21 des Bonddrahtes 4 im Bereich des Bondabschnitts 3 sichern hierbei, dass die untersuchte Bondverbindung in der Thermografieaufnahme zuverlässig identifiziert werden kann für die Prüfung. Dieses zeigt beispielhaft die Thermografieaufnahme in Fig. 4, bei der der Bondabschnitt 3 der untersuchten Bondverbindung mit der Oberflächenstrukturierung 20 versehen ist.

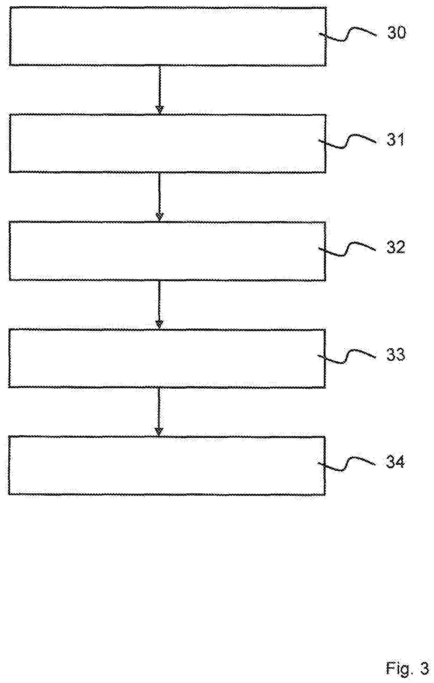

Fig. 3 zeigt eine schematische Darstellung zum Ablauf eines Ausführungsbeispiels für ein Verfahren zum Bestimmen der Bondverbindung 1 in der Bauteilanordnung. In einem Schritt 30 wird die Bondverbindung 1 zwischen dem Bondabschnitt 3 des Bonddrahtes 4 und der metallischen Kontaktstelle 5 hergestellt. Bei dem gezeigten Ausführungsbeispiel erfolgt im Schritt 31 das Strukturieren der deckseitigen Oberfläche des Bonddrahtes 4 im Bereich des Bondabschnittes 3, beispielsweise mittels Laserbearbeitung. In einer alternativen Ausführungsform kann die oberflächenseitige Strukturierung auch schon vor dem Ausbilden der Bondverbindung 1 hergestellt werden. Danach wird die Bondverbindung 1 bestimmt, wobei im Schritt 32 eine Prüfspannung an dem Bonddraht 4 und die Bondverbindung 1 angelegt wird, so dass sich die Bondverbindung 1 erwärmt. Gemäß Schritt 33 wird eine Thermografieaufnahme der erwärmten Bondverbindung erzeugt, beispielsweise unter Verwendung einer Wärmebildkamera. Die Thermografieaufnahme kann eine oder mehrere Thermografieabbildungen und / oder Thermografie-Videofilmaufnahmen umfassen. Schließlich wird im Schritt 34 mit Hilfe der Auswerteeinrichtung 12 bestimmt, ob die Bondverbindung 1 korrekt hergestellt wurde, in dem die Thermografieaufnahme ausgewertet wird. Diese Auswertung kann für ein oder mehrere Bondverbindungen durchgeführt werden. Schließlich kann für die Bauteilanordnung entschieden werden, ob diese korrekt oder nicht korrekt hergestellt wurde bzgl. der Bondverbindungen.

Die in der vorstehenden Beschreibung, den Ansprüchen sowie der Zeichnung offenbarten Merkmale können sowohl einzeln als auch in beliebiger Kombination für die Verwirklichung der verschiedenen Ausführungen von Bedeutung sein.

## Patentansprüche

1. Verfahren zum Bestimmen einer Bondverbindung (1) in einer Bauteilanordnung (2), wobei das Verfahren die folgenden Schritte aufweist:
- Herstellen einer Bondverbindung (1) zwischen einem Bondabschnitt (3) eines Bonddrahtes (4) und einer metallischen Kontaktstelle (5),
- Strukturieren einer deckseitigen Oberfläche des Bonddrahtes (4) im Bereich des Bondabschnittes (3), wobei hierbei eine Strukturierung der deckseitigen Oberfläche ausgebildet wird, die zusätzlich zu einer eventuell zufällig oder herstellungsbedingt auftretenden Oberflächenänderung hergestellt wird und von dieser Oberflächenänderung verschieden ist, und
- Bestimmen der Bondverbindung (1), wobei hierbei
- eine Prüfspannung an den Bonddraht (4) und die Bondverbindung (1) angelegt wird, so dass sich die Bondverbindung (1) aufgrund vom Stromfluss erwärmt,
- Erzeugen einer Thermografieaufnahme für die erwärmte Bondverbindung (1) und
- Bestimmen, ob die Bondverbindung (1) korrekt hergestellt wurde, indem die Thermografieaufhahme mittels digitaler Bildauswertung ausgewertet und hierbei nach charakteristischen Bildmustern gesucht wird, die der Strukturierung der deckseitigen Oberfläche des Bonddrahtes (4) entsprechen und anschließend die charakteristischen Bildmuster zum Bestimmen der Korrektheit der Bondverbindung (1) ausgewertet werden.

2. Verfahren nach Anspruch 1, **dadurch gekennzeichnet, dass** beim Anlegen der Prüfspannung wenigstens eine durchschnittliche Betriebsspannung für die Bondverbindung (1) beim Einsatz der Bauteilanordnung erreicht wird.

3. Verfahren nach Anspruch 1 oder 2, **dadurch gekennzeichnet, dass** beim Bestimmen die Thermografieaufnahme mit einer oder mehreren Referenz-Thermografieaufnahmen verglichen wird.

4. Verfahren nach mindestens einem der vorangehenden Ansprüche, **dadurch gekennzeichnet, dass** mit der Thermografieaufnahme ein Zeitverhalten beim Erwärmen der Bondverbindung erfasst und beim Bestimmen ausgewertet wird.

5. Verfahren nach mindestens einem der vorangehenden Ansprüche, **dadurch gekennzeichnet, dass** beim Bestimmen für die Bondverbindung (1) eine Endtemperatur für das Erwärmen bestimmt wird.

6. Verfahren nach mindestens einem der vorangehenden Ansprüche, **dadurch gekennzeichnet, dass** das Anlegen der Prüfspannung und das Erzeugen der Thermografieaufnahme wiederholt ausgeführt werden.

7. Verfahren nach mindestens einem der vorangehenden Ansprüche, **dadurch gekennzeichnet, dass** beim Erwärmen der Bondverbindung (1) aufgrund der angelegten Prüfspannung ein Temperaturhub von etwa Raumtemperatur auf wenigstens etwa 100°C erzeugt wird.

8. Verfahren nach mindestens einem der vorangehenden Ansprüche, **dadurch gekennzeichnet, dass** das Strukturieren der deckseitigen Oberfläche des Bonddrahtes (4) im Bereich des Bondabschnittes (3) mittels Laserbearbeitung ausgeführt wird.

9. Verfahren nach mindestens einem der vorangehenden Ansprüche, **dadurch gekennzeichnet, dass** das eine weitere Bondverbindung der Bondverbindung (1) vergleichbar bestimmt wird.

10. Verfahren nach mindestens einem der vorangehenden Ansprüche, **dadurch gekennzeichnet, dass** das Bestimmen, ob die Bondverbindung (1) korrekt hergestellt wurde, als eine online-Diagnose ausgeführt wird.

11. Verfahren nach mindestens einem der vorangehenden Ansprüche, **dadurch gekennzeichnet, dass** die Bondverbindung (1) vor dem Bestimmen wenigstens abschnittsweise geschwärzt wird.

12. Prüfvorrichtung zum Bestimmen einer Bondverbindung (1) in einer Bauteilanordnung (2) nach einem Verfahren gemäß mindestens einem der vorangehenden Ansprüche, mit:
- einer Strukturierungseinrichtung (8), die eingerichtet ist, eine deckseitige Oberfläche eines Bonddrahtes (4) im Bereich eines Bondabschnittes (3) zu strukturieren, für den nach oder vor dem Strukturieren eine Bondverbindung (1) zu einer metallischen Kontaktstelle (5) hergestellt ist, wobei hierbei eine Strukturierung der deckseitigen Oberfläche ausgebildet wird, die zusätzlich zu einer eventuell zufällig oder herstellungsbedingt auftretenden Oberflächenänderung hergestellt und von dieser Oberflächenänderung verschieden ist, und
- einer Prüfeinrichtung zum Bestimmen der Bondverbindung (1), wobei die Prüfeinrichtung eingerichtet ist, mittels
- einer Spannungsquelle (10) eine Prüfspannung an den Bonddraht (4) und die Bondverbindung (1) anzulegen, so dass sich die Bondverbindung (1) aufgrund vom Stromfluss erwärmt,
- einer Thermografie-Aufnahmeeinrichtung (11) eine Thermografieaufnahme für die erwärmte Bondverbindung (1) zu erzeugen und
- einer Auswerteeinrichtung (12) zu bestimmen, ob die Bondverbindung (1) korrekt hergestellt wurde, indem die Thermografieaufnahme mittels digitaler Bildauswertung ausgewertet und hierbei nach charakteristischen Bildmustern gesucht wird, die der Strukturierung der deckseitigen Oberfläche des Bonddrahtes (4) entsprechen und anschließend die charakteristischen Bildmuster zum Bestimmen der Korrektheit der Bondverbindung (1) ausgewertet werden.

## Claims

1. A method for determining a bonding connection (1) in a component arrangement (2), wherein the method comprises the following steps:
- producing a bonding connection (1) between a bonding section (3) of a bonding wire (4) and a metal contact point (5),
- structuring a top-side surface of the bonding wire (4) in the region of the bonding section (3), wherein a structuring of the top-side surface is created thereby which is produced in addition to a surface modification which may occur at random or as a result of the production process, and which is different from this surface modification, and
- determining the bonding connection (1), wherein in this process
- a test voltage is applied to the bonding wire (4) and the bonding connection (1), so that the bonding connection (1) heats up as a result of the current flow,
- generating a thermographic image for the heated bonding connection (1) and
- determining whether the bonding connection (1) was produced correctly by performing an evaluation of the thermographic image using digital image analysis and as part of this process searching for characteristic image patterns that correspond to the structuring of the top-side surface of the bonding wire (4), and subsequently evaluating the characteristic image patterns to determine the correctness of the bonding connection (1).

2. The method according to Claim 1, **characterized in that** when the test voltage is applied at least one average operating voltage is reached for the bonding connection (1) when the component arrangement is used.

3. The method according to Claim 1 or 2, **characterized in that** during the determination the thermographic image is compared with one or more reference thermographic images.

4. The method according to at least one of the preceding claims, **characterized in that** the thermographic image captures a response over time as the bonding connection is heated, which response is evaluated during the determination.

5. The method according to at least one of the preceding claims, **characterized in that** a final temperature for the heating is determined during the determination of the bonding connection (1).

6. The method according to at least one of the preceding claims, **characterized in that** the application of the test voltage and the generation of the thermographic image are carried out repeatedly.

7. The method according to at least one of the preceding claims, **characterized in that** when the bonding connection (1) is heated due to the applied test voltage a rise in temperature from about room temperature to at least about 100 °C is produced.

8. The method according to at least one of the preceding claims, **characterized in that** the structuring of the top-side surface of the bonding wire (4) is carried out in the region of the bonding section (3) by means of laser treatment.

9. The method according to at least one of the preceding claims, **characterized in that** a further bonding connection to the bonding connection (1) is determined similarly.

10. The method according to at least one of the preceding claims, **characterized in that** the determination as to whether the bonding connection (1) was produced correctly is carried out as an online diagnosis.

11. The method according to at least one of the preceding claims, **characterized in that** at least sections of the bonding connection (1) are blackened before the determination.

12. A test device for determining a bonding connection (1) in a component arrangement (2) in a method according to at least one of the preceding claims, with:
- a structuring device (8) that is designed to structure a top-side surface of a bonding wire (4) in the region of a bonding section (3), for which a bonding connection (1) with a metal contact point (5) is produced before or after the structuring, wherein a structuring of the top-side surface is formed thereby which is produced in addition to a surface modification which may occur at random or as a result of the production process, and which is different from this surface modification, and
- a test device for determining the bonding connection (1), wherein the test device is configured
- to apply a test voltage from a voltage source (10) to the bonding wire (4) and the bonding connection (1), so that the bonding connection (1) heats up as a result of the current flow,
- to generate a thermographic image for the heated bonding connection (1) using a thermographic image capture device (11), and
- to determine with an evaluation device (12) whether the bonding connection (1) was produced correctly by performing an evaluation of the thermographic image using digital image analysis and as part of this process searching for characteristic image patterns that correspond to the structuring of the top-side surface of the bonding wire (4), and subsequently evaluating the characteristic image patterns to determine the correctness of the bonding connection (1).

## Revendications

1. Procédé pour déterminer une connexion soudée (1) dans une configuration de composants (2), le procédé comportant les étapes suivantes, consistant à :
- créer une connexion soudée (1) entre un segment de connexion (3) d'un câble de connexion (4) et un point de contact métallique (5),
- structurer une surface du côté supérieur du câble de connexion (4), dans la région du segment de connexion (3), à cet effet, une structuration de la surface du côté supérieur étant réalisée, qui est créée additionnellement à une modification de surface éventuellement aléatoire ou due à la fabrication et qui est différente de ladite modification de surface, et
- déterminer la connexion soudée (1), à cet effet
- une tension d'essai étant appliquée sur le câble de connexion (4) et sur la connexion soudée (1), de telle sorte que la connexion soudée (1) s'échauffe en raison du passage de courant,
- générer un cliché thermographique pour la connexion soudée (1) échauffée et
- déterminer si la connexion soudée (1) a été créée correctement, en ce que le cliché thermographique est évalué par évaluation numérique d'images et en qu'à cet effet, des modèles d'images caractéristiques sont recherchés, qui correspondent à la structuration de la surface du côté supérieur du câble de connexion (4) et en ce que par la suite, les modèles d'images caractéristiques sont évalués pour déterminer le caractère correct de la connexion soudée (1).

2. Procédé selon la revendication 1, **caractérisé en ce que** lors de l'application de la tension d'essai, au moins une tension de service moyenne pour la connexion soudée (1) lors de l'utilisation de la configuration de composants est atteinte.

3. Procédé selon la revendication 1 ou 2, **caractérisé en ce que**, lors de la détermination, on compare le cliché thermographique avec un ou plusieurs clichés thermographiques de référence.

4. Procédé selon au moins l'une quelconque des revendications précédentes, **caractérisé en ce qu'**avec le cliché thermographique, on enregistre un comportement dans le temps lors de l'échauffement de la connexion soudée et on l'évalue lors de la détermination.

5. Procédé selon au moins l'une quelconque des revendications précédentes, **caractérisé en ce que** lors de la détermination, on détermine pour la connexion soudée (1) une température finale d'échauffement.

6. Procédé selon au moins l'une quelconque des revendications précédentes, **caractérisé en ce que** qu'on procède de manière réitérée à l'application de la tension d'essai et à la génération du cliché thermographique.

7. Procédé selon au moins l'une quelconque des revendications précédentes, **caractérisé en ce que** lors de l'échauffement de la connexion soudée (1), on génère en raison de la tension d'essai appliquée une course de température d'environ la température ambiante à au moins 100 °C.

8. Procédé selon au moins l'une quelconque des revendications précédentes, **caractérisé en ce qu'**on réalise la structuration de la surface du côté supérieur du câble de connexion (4) dans la zone du segment de connexion (3) par usinage au laser.

9. Procédé selon au moins l'une quelconque des revendications précédentes, **caractérisé en ce qu'**on détermine une connexion soudée supplémentaire, de manière comparable à celle pour la connexion soudée (1).

10. Procédé selon au moins l'une quelconque des revendications précédentes, **caractérisé en ce qu'**on réalise la détermination si la connexion soudée (1) a été créée correctement sous la forme d'un diagnostic en ligne.

11. Procédé selon au moins l'une quelconque des revendications précédentes, **caractérisé en ce qu'**on noircit au moins par segments la connexion soudée (1) avant la détermination.

12. Dispositif d'essai pour déterminer une connexion soudée (1) dans une configuration de composants (2) d'après un procédé selon l'une quelconque des revendications précédentes, comprenant :
- un système de structuration (8), qui est aménagé pour structurer une surface du côté supérieur d'un câble de connexion (4) dans la zone d'un segment de connexion (3), pour lequel avant ou après la structuration est créée une connexion soudée (1) vers un point de contact métallique (5), à cet effet étant réalisée une structuration de la surface du côté supérieur qui est créée additionnellement à une modification de surface éventuellement aléatoire ou due à la fabrication et qui est différente de ladite modification de surface, et
- un système d'essai pour déterminer la connexion soudée (1), ledit système d'essai étant aménagé
- pour appliquer au moyen d'une source de tension (10) une tension d'essai sur le câble de connexion (4) et sur la connexion soudée (1), de sorte que la connexion soudée (1) s'échauffe en raison du passage de courant,
- pour générer au moyen d'un système d'enregistrement thermographique (11) un cliché thermographique pour la connexion soudée (1) échauffée et
- pour déterminer au moyen d'un système d'évaluation (12) si la connexion soudée (1) a été créée correctement, en ce que le cliché thermographique est évalué par évaluation numérique d'images et en qu'à cet effet, des modèles d'images caractéristiques sont recherchés, qui correspondent à la structuration de la surface du côté supérieur du câble de connexion (4) et en ce que par la suite, les modèles d'images caractéristiques sont évalués pour déterminer le caractère correct de la connexion soudée (1).
